# EUROPEAN PATENT APPLICATION

(11) **EP 0 747 959 A2**
(43) Date of publication of application: **11.12.1996**
(21) Application number: 96303325.3
(22) Date of filing: 13.05.1996
(51) Int. Cl.: H01L 27/08

(54) **Precision capacitor ladder using differential equal-perimeter pairs**

(30) Priority: 07.06.1995 US 488098
(71) Applicant: SGS-THOMSON MICROELECTRONICS, INC., Carrollton Texas 75006-5039 (US)
(72) Inventor: Groover, Robert O., Dallas, Texas 75248 (US)
(74) Representative: Palmer, Roger

(57) **Abstract**

An integrated circuit capacitor ladder which uses a differential pair of capacitors for each step in the ladder. By pairing a square with a rectangle of equal perimeter, the contributions of edge and corner elements can be cancelled out. This adds area and complexity, but greatly increases the precision of scaling.

This is done, for example, by using paired MOS capacitors for each step in the array: for the even-numbered steps, one of these capacitors will be drawn as a square, and the other will be an elongated minimum-width rectangle of equal perimeter. The area differences between the square capacitor and the thin capacitor will then be stepped to provide the scale of powers of two. (For the odd-numbered steps, the next lower differential pair can be replicated twice, or non-integer size values can be used.)

## Description

The present invention relates to analog integrated circuits containing capacitor arrays, especially capacitor arrays having a capacitance range of at least 100:1.

A well-known problem with integrated circuit capacitors is that their capacitance does not scale directly with drawn area. The capacitance at the edge will be affected by linewidth variations, and also by fringing field effects. This is not a problem for very small arrays, but becomes more of a problem as the number of capacitors in the array increases. Thus if we try to build a chain of 8 capacitors scaled by powers of two, we may find that the transition from 01111111 to 1000000 is in the wrong direction, or is excessively large.

MOS capacitors provide a fairly high raw capacitance per unit area, but the capacitance of MOS capacitors is affected by a number of process parameters, e.g. gate oxide thickness, substrate doping, well doping if used, VT doping if used, linewidth variation (in polysilicon and in active), and variations in the degree of birds beak encroachment on the active area, and hence variation in the capacitance of a capacitor whose area is determined by an active area pattern. Moreover, variations in field oxidation conditions and/or channel stop implant may produce some variation in the doping underlying the birds beak extension, and this too will have some effect on the capacitance contribution at the perimeter of a MOS capacitor.

This is particularly a problem in converters (ADCs and DACs), where capacitor ladders are very commonly used. However, similar problems may arise in many other analog circuit contexts. Accurate capacitor ladders provide digitally selectable reactances which can be useful for various telecomm, RF, and switched-capacitor circuits.

Many attempts have been made to compensate for this problem. For example, U.S. Application 08/356,075 filed 12/14/94, which is hereby incorporated by reference, describes an innovative way to correct for capacitor nonlinearity; but the present application proposes a hardware technique to effectively eliminate it.

The present application discloses a circuit architecture which uses a differential pair of capacitors for each step in the ladder. By pairing a square with a rectangle of equal perimeter, the contributions of edge and corner elements can be cancelled out. This adds area and complexity, but greatly increases the precision of scaling. (Of course the absolute capacitance per unit area is still dependent on process variables, but the present invention lets designers specify capacitance ratios with greatly increased precision.) The idea is that the long thin capacitor should have exactly the same variation in capacitance contributions due to straight-line perimeter length, and almost exactly the same variation in corner-dependent capacitances, so we are left with a net capacitance due solely to the homogeneous central area of the more square capacitor. These central elements are determined directly by the drawn geometry, and hence can be more accurately designed into desired proportions.

This is done, for example, by using paired MOS capacitors for each step in the array: for the even-numbered steps, one of these capacitors will be drawn as a square, and the other will be an elongated minimum-width rectangle of equal perimeter. The area differences between the square capacitor and the thin capacitor will then be stepped to provide the scale of powers of two. (For the odd-numbered steps, the next lower differential pair can be replicated, or alternatively non-integer size values can be used.)

It is believed that the use of differently shaped capacitors to analyze the various components of capacitance is known in test structures, but the disclosed inventions use a circuit combination of different shapes in a way which cancels some of the most variable contributions to capacitance.

The disclosed inventions will be described with reference to the accompanying drawings, which show important sample embodiments of the invention and which are incorporated in the specification hereof by reference, wherein:
**Figure 1** shows drawn outlines of a differential pair of capacitors.
**Figure 2** shows an example of a differential connection of two parallel arrays of capacitors to provide a linearized net signal.

The numerous innovative teachings of the present application will be described with particular reference to the presently preferred embodiment (by way of example, and not of limitation), in which:

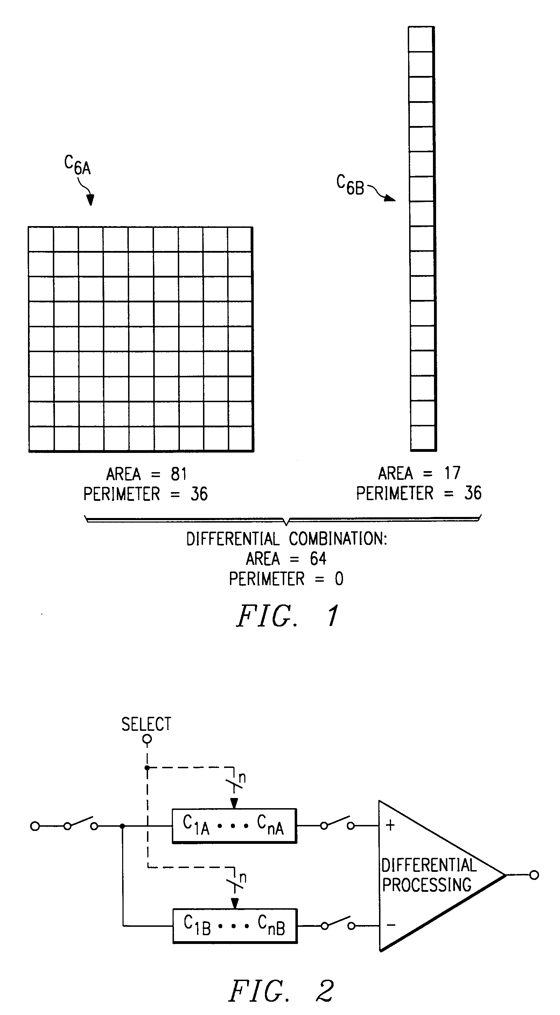

**Figure 1** shows drawn outlines of one such differential pair of capacitors. The left element C_{6A} has an area of 81λ² (where λ is the minimum geometry) and a perimeter of 36λ. The right element C_{6B} has an area of 17λ² and a perimeter of 36λ. The resulting differential combination C₆ then has a net effective area of 64λ² and a perimeter of 0λ.

The most area-conservative way to use this invention is to use a square for one capacitor C_{nA} of a differential pair, and to use a minimum-width linear capacitor C_{nB} for the other element of the differential pair. A square which is n+1 units on a side will have an area of n²+2n+1 and a perimeter of 4n+4. The same perimeter can be achieved by a narrower capacitor C_{nB} which is one unit wide and (2n+1) units long, and therefore has a drawn area of 2n+1. Thus, the difference between the two will produce an equivalent capacitor which has a net effective area of n², and a net effective perimeter contribution of 0.

This numerical relation works for all even powers of two; for odd powers of two a nonintegral value can be used for the larger dimensions (IF the design software and mask fabrication permit this), or (more simply) two differential capacitors can be paralleled. For example, two instances of capacitor C_{6A} on the left side of Figure 1 can be connected in parallel to provide a capacitor C_{7A}, and two examples of capacitor C_{6B} on the right side of Figure 1 can be connected in parallel to provide a capacitor C_{7B}, and capacitors C_{7A} and C_{7B} can then be connected differentially to provide a capacitor C₇ with an effective area of 128λ².

The technique of parallelling differential pairs also provides some layout flexibility to avoid the use of very large linear elements. Moreover, by alternating the A and B capacitors in a 2x2 grid such as

| | |
|---|---|
| C_{nA} | C_{nB} |
| C_{nB} | C_{nA} |

parameter variation within the wafer can be even more accurately compensated. (This is a conventional design technique.)

Various circuit techniques can be used to subtract the small capacitors from the large capacitors; in fact, some of these are already used in trimmed A-D arrays. **Figure 2** very schematically shows such a differential connection. The A and B capacitor arrays receive the same digital selection signal, so each selected A capacitor is matched by a selected B capacitor. The differential processing stage is shown very schematically as an op amp, but in practice a variety of circuit techniques can be used to perform the needed subtraction in voltage, current, or charge domains. For example, charge subtraction in the larger capacitor array can itself be used to produce the net difference.

Of course it is slightly more inconvenient to use a differential connection for a capacitor ladder, but such connections are already commonly used for correction arrays. (An important technique in converters is the use of error arrays or correction arrays. In the classical form the main array of capacitors is paralleled by a second array which stores offset values. Ideally the circuit can run a self-calibration procedure (e.g. when powered up), and store corresponding offset voltages in the error array. These techniques are described in the various Tan *et al*. and Hester *et al*. articles cited below.) As discussed in these articles, such circuits use a correction array of capacitors which are used to store charge values indicating offsets. Thus, such arrays provide in effect a calibration adjustment, indicated by a charge value, for each of the capacitors in the primary capacitor ladder. This is a significantly different idea from the present invention, which simply provides a more accurate scaling of the capacitor values themselves. Of course, in alternative embodiments, error correcting or self-calibration networks can be used in combination with differential capacitor structures under the present invention.

Many other differential connection have been presented in the literature; *see e.g.* Lee, "A 12-b 600 ks/s digitally self-calibrated pipelined algorithmic ADC," 29 IEEE J. SOLID-STATE CIRCUITS 509 (1994); Ginetti *et al*., "A CMOS 13 bit cyclic RSD A/D converter," ESSCIRC '91 PROCEEDINGS 245; Yamada *et al*., "A switched-capacitor interface for capacitive pressure sensors," 41 IEEE TRANS'NS INSTRUMENTATION AND MEASUREMENT 81 (1992); Esashi *et al*., "Common two lead wires sensing system," TRANSDUCERS '91 330; Schoneberg *et al*., "CMOS integrated capacitive pressure transducer with on-chip electronics and digital calibration capability," TRANSDUCERS '91 304 (1991); Adams *et al*., "Theory and practical implementation of a fifth-order sigma-delta A/D converter," 39 J. THE AUDIO ENGINEERING SOCIETY 515 (1991); Tan *et al*., "A 5 V, 16 b 10 mu s differential CMOS ADC," 1990 ISSCC DIGEST 166; Tan *et al*., "Error correction techniques for high-performance differential A/D converters," 25 IEEE J. SOLID-STATE CIRCUITS 1318 (1990); Morris *et al*., "Application-oriented data converters for a CMOS cell library," 7 J. SEMICUSTOM ICS 26 (1990); Rebeschini *et al*., "A 16-b 160-kHz CMOS A/D converter using sigma-delta modulation," 25 IEEE J. SOLID-STATE CIRCUITS 431 (1990); Hester *et al*., "Fully differential ADC with rail-to-rail common-mode range and nonlinear capacitor compensation," 25 IEEE J. SOLID-STATE CIRCUITS 173 (1990); Ueno *et al*., "A high-accuracy switched-capacitor pipelined analog-to-digital converter," E72 TRANSACTIONS OF THE INSTITUTE OF ELECTRONICS, INFORMATION AND COMMUNICATION ENGINEERS E 1285 (1989); Yung *et al*., "An error-compensation A/D conversion technique," 1989 IEEE INTERNATIONAL SYMPOSIUM ON CIRCUITS AND SYSTEMS 258; Ramet, "A 13-bit, 160 kHz, differential analog to digital converter," 1989 ISSCC DIGEST 20; Said, "Novel drift-free fully differential switched capacitor filter based on the simulation of ladder structures," 66 INTERNATIONAL J. ELECTRONICS 801 (1989); Doernberg *et al*., "A 10-bit 5-Msample/s CMOS two-step flash ADC," 24 IEEE J. SOLID-STATE CIRCUITS 241 (1989); Song *et al*., "A 12-bit 1-Msample/s capacitor error-averaging pipelined A/D converter," 23 IEEE J. SOLID-STATE CIRCUITS 1324 (1988); Doernberg *et al*., "A 10-bit 5 Msample/sec CMOS 2-step flash ADC," 1988 CUSTOM INTEGRATED CIRCUITS CONFERENCE paper 18.6; Park *et al*., "An MOS switched-capacitor readout amplifier for capacitive pressure sensors," IEEE 1983 CUSTOM INTEGRATED CIRCUITS CONFERENCE 380 (1983); and Hester *et al*., "A monolithic data acquisition channel," 31 IEEE TRANS'NS ACOUSTICS, SPEECH AND SIGNAL PROCESSING 305 (1983); all of which are hereby incorporated by reference.

In an alternative class of embodiments, the primary capacitors may be given an aspect ratio other than perfectly square (especially for the larger capacitors) and/or the secondary capacitors may be made more than one unit wide. The latter variation can be convenient for high precision, to allow best compensation for geometry-dependent field enhancement (since the capacitance of a 180 degree bend is not necessary equal to the sum of the capacitances of two 90 degree bends).

Note that the square + rectangle embodiment of Figure 1 provides not only equal perimeters, but also an equal number of corners in the A and B capacitors. This provides compensation for any effects due to electric-field enhancement at the corners. It may alternatively be possible to use meandered lines for the larger linear capacitors C_{nB}, but this would have to be tried or 3D-simulated to make sure that the perimeter compensation still provides sufficient accuracy.¹
¹Geometry-dependent electric field enhancement is a familiar phenomenon, discussed in any elementary physics textbook, which causes the electric field of a charged body to be increased at corners of a charged body. The interaction of such geometric effects with the details of junction curvature and doping-profile-dependent CV relations is not trivial.

Note that this technique is not only applicable to MOS capacitors, but can also be used in poly-to-poly capacitors. Such capacitors are less susceptible to some sources of process variation, but still are susceptible to linewidth variation and (like any capacitor) to fringing field effects. The present invention compensates for both of these effects.

For maximum accuracy in a CMOS process, the capacitor is preferably defined in poly, and the poly is surrounded by active which receives neither P+ nor N+ source/drain implant. Use of well and VT doping can be selected to maximize specific capacitance within the limits of tolerable CV dependence (MOS capacitors inherently have some variation of capacitance with voltage).

In an alternative class of embodiments, the smallest bits do not have to use the differential capacitor pairs, since the LSBs are not the most critical contributor to total error (which is cumulative).

According to a disclosed class of innovative embodiments, there is provided: An integrated circuit capacitor array, comprising: first and second arrays of capacitors, connected to receive identical selection inputs and to selectively connect and disconnect capacitors accordingly; wherein individual capacitors of said first array each have a perimeter which is equal to that of a corresponding capacitor in said second array, and an area which differs from that of said corresponding capacitor by a desired proportional capacitance fraction.

### Modifications and Variations

As will be recognized by those skilled in the art, the innovative concepts described in the present application can be modified and varied over a tremendous range of applications, and accordingly the scope of patented subject matter is not limited by any of the specific exemplary teachings given. For example, as will be obvious to those of ordinary skill in the art, other circuit elements can be added to, or substituted into, the specific circuit topologies shown.

## Claims

1. An integrated circuit capacitor array, comprising:
first and second arrays of capacitors, connected to receive identical selection inputs and to selectively connect and disconnect capacitors accordingly;
wherein individual capacitors of said first array each have a perimeter which is equal to that of a corresponding capacitor in said second array, and an area which differs from that of said corresponding capacitor by a desired proportional capacitance fraction.
